# EUROPÄISCHE PATENTSCHRIFT

(11) **EP 4 250 771 B1**
(45) Veröffentlichungstag und Bekanntmachung des Hinweises auf die Patenterteilung: **29.10.2025**
(21) Anmeldenummer: 23157058.1
(22) Anmeldetag: 16.02.2023
(51) Int. Cl.: H04R 25/00

(54) **HÖRGERÄT**
HEARING AID
DISPOSITIF AUDITIF

(30) Priorität: 21.03.2022 DE 102022202761
(43) Veröffentlichungstag der Anmeldung: 27.09.2023
(73) Patentinhaber: Sivantos Pte. Ltd., Singapore 539775 (SG)
(72) Erfinder: LOW, Keh Hoe, 730734 Singapur (SG)
(74) Vertreter: FDST Patentanwälte

(56) Entgegenhaltungen:
- DE-A1- 102012 214 466
- DE-A1- 102021 201 095
- DE-B3- 102004 017 832
- DE-B3- 102006 026 753

## Beschreibung

Die Erfindung betrifft ein Hörgerät. Das Hörgerät weist eine Leiterplatte, eine Batteriezelle und eine Antenne auf.

Personen, die unter einer Verminderung des Hörvermögens leiden, verwenden üblicherweise ein Hörhilfegerät. Hierbei wird meist mittels eines Mikrofons, also eines elektromechanischen Schallwandlers, ein Umgebungsschall in ein elektrisches (Audio-/Schall-)Signal gewandelt, sodass das elektrische Signal erfasst wird. Die erfassten elektrischen Signale werden mittels einer Verstärkerschaltung bearbeitet und mittels eines weiteren elektromechanischen Wandlers in Form eines Hörers in den Gehörgang der Person eingeleitet. Meist erfolgt zudem eine Bearbeitung der erfassten Schallsignale, wofür üblicherweise ein Signalprozessor der Verstärkerschaltung verwendet wird. Hierbei ist die Verstärkung auf einen etwaigen Hörverlust des Hörgeräteträgers abgestimmt. Die (Schall-)Wandler und die Verstärkerschaltung sind üblicherweise in einem Gehäuse angeordnet und auf diese Weise vor Umwelteinflüssen zumindest teilweise geschützt.

Die Steuerung der Funktionen des Hörgeräts erfolgt beispielsweise mittels eines in das Gehäuse eingebrachten, manuell zu bedienenden Schalters. Infolgedessen ist es erforderlich, dass das Gehäuse eine bestimmte Mindestgröße aufweist, sodass das Hörgerät vergleichsweise sichtbar ist. Zur Abhilfe hiervon ist es bekannt, das Hörgerät mittels eines weiteren Geräts, wie einer Fernbedienung oder eines Smartphones, zu steuern, wobei zwischen dem weiteren Gerät und dem Hörgerät eine Funkverbindung erstellt ist. Hierfür ist es erforderlich, dass das Hörgerät eine Funkvorrichtung aufweist, die mit einer Antenne verbunden ist. Mittels der Funkvorrichtung können zudem zusätzlich Audiosignale empfangen werden, sodass diese in den Gehörgang der Person eingespeist werden. Somit ist ein Funktionsumfang des Hörgeräts vergrößert.

Die Antenne ist zum Beispiel mittels einer Spule bereitgestellt, die an einer Leiterplatte befestigt ist, mittels derer auch zumindest teilweise die Verstärkerschaltung realisiert ist. Infolgedessen ist ein erforderlicher Bauraum wiederum vergrößert. Auch sind zusätzliche Bauteile erforderlich, die an der Leiterplatte montiert werden, weswegen eine Herstellungszeit verlängert ist. Alternativ hierzu wird beispielsweise eine Leiterbahn der Leiterplatte als Antenne herangezogen. Infolgedessen ist kein zusätzliches Bauteil erforderlich, jedoch ist ein Platzbedarf im Vergleich zu der Verwendung der Spule weiter vergrößert.

Aus DE 10 2012 214 466 A1 ist ein wiederaufladbarer Batteriepack bekannt. Dieser umfasst eine wiederaufladbare Batteriezelle, eine Ladeelektronik zum Aufladen der Batteriezelle, eine Nutzsignalelektronik zum Erzeugen eines Nutzsignals, mindestens zwei Nutzsignalkontakte zum Abgeben des Nutzsignals, und eine Kapselung zum Schutz gegen das Eindringen von Feuchtigkeit und Verunreinigungen.

In DE 10 2021 201 095 A1 ist eine platzsparende Antenne für ein Hörinstrument offenbart. Die Antenne weist eine erste Antennenfläche und eine zweite Antennenfläche auf, die jeweils aus magnetischer, flexibler Folie gebildet sind. Die Antenne weist weiterhin eine aus einem magnetischen Material gebildete oder eine magnetische Schicht umfassende Basis auf, die die beiden Antennenflächen miteinander verbindet, wobei die beiden Antennenflächen von der Basis in gleicher Richtung abgewinkelt sind.

Der Erfindung liegt die Aufgabe zugrunde, ein besonders geeignetes Hörgerät anzugeben, wobei insbesondere eine Baugröße verringert und/oder eine Montage vereinfacht ist.

Erfindungsgemäß wird diese Aufgabe durch die Merkmale des Anspruchs 1 gelöst. Vorteilhafte Weiterbildungen und Ausgestaltungen sind Gegenstand der Unteransprüche.

Beispielsweise ist das Hörgerät ein Kopfhörer oder umfasst einen Kopfhörer, und das Hörgerät ist zum Beispiel ein Headset. Besonders bevorzugt ist das Hörgerät jedoch ein Hörhilfegerät. Das Hörhilfegerät dient der Unterstützung einer unter einer Verminderung des Hörvermögens leidenden Person. Mit anderen Worten ist das Hörhilfegerät ein medizinisches Gerät, mittels dessen beispielsweise ein partieller Hörverlust ausgeglichen wird. Das Hörhilfegerät ist beispielsweise ein "Recei-ver-in-the-canal"-Hörhilfegerät (RIC; Ex-Hörer-Hörhilfegerät), ein Im-Ohr-Hörhilfegerät, wie ein "in-the-ear"-Hörhilfegerät, ein "in-the-canal"-Hörhilfegerät (ITC) oder ein _{"}complete-in-canal"-Hörhilfegerät (CIC), eine Hörbrille, ein Taschenhörhilfegerät, ein Knochenleitungs-Hörhilfegerät oder ein Implantat. Besonders bevorzugt ist das Hörhilfegerät ein Hinter-dem-Ohr-Hörhilfegerät ("Behind-the-Ear"-Hörhilfegerät), das hinter einer Ohrmuschel getragen wird.

Das Hörgerät ist vorgesehen und eingerichtet, am menschlichen Körper getragen zu werden. Mit anderen Worten umfasst das Hörgerät bevorzugt eine Haltevorrichtung, mittels deren eine Befestigung am menschlichen Körper möglich ist. Sofern es sich bei dem Hörgerät um ein Hörhilfegerät handelt, ist das Hörgerät vorgesehen und eingerichtet, beispielsweise hinter dem Ohr oder innerhalb eines Gehörgangs angeordnet zu werden. Insbesondere ist das Hörgerät kabellos und dafür vorgesehen und eingerichtet, zumindest teilweise in einen Gehörgang eingeführt zu werden.

Das Hörgerät umfasst zum Beispiel ein Mikrofon, das dem Erfassen von Schall dient. Insbesondere wird bei Betrieb mittels des Mikrofons ein Umgebungsschall erfasst, oder zumindest ein Teil hiervon. Bei dem Mikrofon handelt es sich insbesondere um einen elektromechanischen Schallwandler. Das Mikrofon weist beispielsweise lediglich eine einzige Mikrofoneinheit oder mehrere Mikrofoneinheiten auf, die miteinander wechselwirken. Jede der Mikrofoneinheiten weist zweckmäßigerweise eine Membran auf, die anhand von Schallwellen in Schwingungen versetzt wird, wobei die Schwingungen mittels eines entsprechenden Aufnahmegeräts, wie eines Magneten, der in einer Spule bewegt wird, in ein elektrisches Signal gewandelt wird. Somit ist es möglich, mittels der jeweiligen Mikrofoneinheit ein Audiosignal zu erfassen, das auf dem auf die Mikrofoneinheit auftreffendem Schall basiert. Die Mikrofoneinheiten sind insbesondere unidirektional ausgestaltet. Das Mikrofon ist zweckmäßigerweise zumindest teilweise innerhalb eines Gehäuses des Hörgeräts angeordnet und somit zumindest teilweise geschützt.

Zweckmäßigerweise weist das Hörgerät einen Hörer zum Ausgeben eines Ausgabesignals auf. Das Ausgabesignal ist hierbei insbesondere ein elektrisches Signal. Der Hörer ist ein elektromechanischer Schallwandler, vorzugsweise ein Lautsprecher. Je nach Ausgestaltung des Hörgeräts ist im bestimmungsgemäßen Zustand der Hörer zumindest teilweise innerhalb eines Gehörgangs eines Trägers des Hörgeräts, also einer Person, angeordnet oder zumindest akustisch mit diesem verbunden. Das Hörgerät dient insbesondere hauptsächlich dem Ausgeben des Ausgabesignals mittels des Hörers, wobei ein entsprechender Schall erstellt wird. Mit anderen Worten ist die Hauptfunktion des Hörgeräts bevorzugt das Ausgeben des Ausgabesignals. Das Ausgabesignal ist dabei insbesondere zumindest teilweise in Abhängigkeit des mittels des Mikrofons erfassten Schalls erstellt.

Das Hörgerät umfasst zweckmäßigerweise einen Signalprozessor, der geeigneterweise eine Signalverarbeitungseinheit bildet oder zumindest ein Bestandteil hiervon ist. Der Signalprozessor ist beispielsweise ein digitaler Signalprozessor (DSP) oder mittels analoger Komponenten realisiert. Mittels des Signalprozessors erfolgt insbesondere eine Anpassung des mittels des etwaigen Mikrofons erstellten (Au-dio-)Signals, vorzugsweise in Abhängigkeit eines etwaigen Hörverlust eines Trägers des Hörgeräts. Zweckmäßigerweise ist zwischen dem Mikrofon und der Signalverarbeitungseinheit, beispielsweise den Signalprozessor, ein A/D-Wandler angeordnet, sofern der Signalprozessor als digitaler Signalprozessor ausgestaltet ist. Der Signalprozessor ist insbesondere in Abhängigkeit eines Parametersatzes eingestellt. Mittels des Parametersatzes wird dabei eine Verstärkung in unterschiedlichen Frequenzbereichen vorgegeben, sodass das mittels des Mikrofons erstellte Signal entsprechend bestimmter Vorgaben bearbeitet wird, insbesondere in Abhängigkeit eines Hörverlust des Trägers des Hörgeräts. Besonders bevorzugt umfasst das Hörgerät zusätzlich einen Verstärker, oder der Verstärker ist mittels des Signalprozessors zumindest teilweise gebildet. Beispielsweise ist der Verstärker signaltechnisch dem Signalprozessor vor- oder nachgeschaltet.

Das Hörgerät weist eine Leiterplatte auf, an der ein Batteriemodul befestigt ist. Insbesondere ist die Leiterplatte starr ausgestaltet und vorzugsweise aus einem glasfaserverstärkten Epoxidharz gefertigt. An dem Epoxidharz befestigt oder in dieses eingebettet sind zweckmäßigerweise Leiterbahnen, die vorzugsweise aus einem Kupfer erstellt sind. Insbesondere ist das Batteriemodul an zumindest einer der Leiterbahnen befestigt, vorzugsweise mit dieser verlötet. Auf diese Weise sind zur Befestigung des Batteriemoduls keine weiteren Bauteile erforderlich. Alternativ oder in Kombination hierzu sind zusätzliche Befestigungselemente vorhanden, wie beispielsweise Clips oder Dome, mittels derer das Batteriemodul an der Leiterplatte gehalten ist. Somit ist eine Robustheit erhöht.

Bevorzugt sind an der Leiterplatte auch weitere elektrische und/oder elektronische Komponenten des Hörgeräts befestigt, wie beispielsweise der etwaige Verstärker und/oder sonstigen Bestandteile der etwaigen Signalverarbeitungseinheit. Besonders bevorzugt weist das Hörgerät lediglich diese Leiterplatte als einzige Leiterplatte auf. Auf diese Weise ist eine Anzahl an benötigten Bauteilen sowie ein benötigter Bauraum reduziert, und eine Fertigung des Hörgeräts ist vereinfacht.

Insbesondere erfolgt bei Betrieb des Hörgeräts eine Bestromung der einzelnen Komponenten des Hörgeräts mittels des Batteriemoduls. Mit anderen Worten ist mittels des Batteriemoduls ein Energiespeicher des Hörgeräts bereitgestellt, der für den Betrieb verwendet wird. Zweckmäßigerweise ist das Batteriemodul der einzige Energiespeicher des Hörgeräts. Insbesondere erfolgt somit bei Betrieb des Hörgeräts eine Bestromung des etwaigen Mikrofons/Hörers oder sonstige Komponenten des Hörgeräts mittels des Batteriemoduls.

Das Batteriemodul weist eine Batteriezelle mit einem Gehäuse auf. Hierbei dient das Gehäuse dem Schutz der weiteren Komponenten der Batteriezelle, die zweckmäßigerweise innerhalb des Gehäuses angeordnet sind. Vorzugsweise bildet das Gehäuse die äußere Begrenzung der Batteriezelle. Die Batteriezelle umfasst Elektroden und einen Elektrolyten. Beispielsweise ist der Elektrolyt flüssig oder als Festkörper ausgestaltet. Besonders bevorzugt ist die Batteriezelle eine Festkörperbatterie. Die Elektroden/Elektrolyt sind direkt innerhalb des Gehäuses angeordnet, und zwischen diesen ist kein weiteres Bauteil vorhanden. Zumindest jedoch erfolgt mittels des Gehäuses im Wesentlichen die Abschirmung der Elektroden/Elektrolyten von der Umgebung, sodass ein Austritt und/oder eine ungewünschte Reaktion der einzelnen Bestandteile der Batteriezelle mit der Umgebung mittels des Gehäuses vermieden ist. Da keine weiteren Bauteile vorhanden sind, ist eine Energiedichte der Batteriezelle erhöht und ein Gewicht verringert. Insbesondere ist die Batteriezelle als Lithiumionen-Batteriezelle ausgestaltet und/oder als Sekundärbatterie. Mit anderen Worten ist die Batteriezelle wiederladbar ausgestaltet und zweckmäßigerweise unlösbar an der Leiterplatte befestigt. Auf diese Weise ist eine Robustheit erhöht und eine Konstruktion vereinfacht.

Das Batteriemodul weist ferner eine Antenne auf, die in das Gehäuse integriert ist. Mit anderen Worten ist die Antenne an dem Gehäuse befestigt und unlösbar mit diesem verbunden, sodass ein Ablösen der Antenne nicht möglich ist. Zum Beispiel befindet sich die Antenne innerhalb des Gehäuses oder besonders bevorzugt außerhalb des Gehäuses, wobei die Antenne beispielsweise an dessen Außenseite unlösbar befestigt ist, sodass auf diese Weise die Integration erfolgt. Die Antenne dient insbesondere der Herstellung einer Funkverbindung des Hörgeräts mit weiteren Geräten und ist hierfür geeignet, insbesondere vorgesehen und eingerichtet. Zweckmäßigerweise umfasst das Hörgerät eine Funkvorrichtung, die im Montagezustand signaltechnisch mit der Antenne verbunden ist. Bei Betrieb werden mittels der Funkvorrichtung Signale über die Antenne ausgesandt und/oder empfangen, und die Funkvorrichtung, die eine Kommunikationseinrichtung ist oder zumindest als diese dient, weist hierfür insbesondere einen Empfänger/Sender auf. Insbesondere ist die Funkvorrichtung gemäß einem bestimmten Standard betrieben, wie einem WLAN-, Bluetooth- und/oder Mobilfunkstandards. Zumindest jedoch ist die Antenne zweckmäßigerweise für einen entsprechenden Standard geeignet und somit für das Senden/Empfangen von (Funk-)Signalen in den entsprechenden Frequenzbereichen.

Aufgrund der Integration der Antenne in das Gehäuse ist eine stabile Verbindung zwischen diesen vorhanden, und es ist nicht erforderlich, die Antenne separat an der Leiterplatte zu befestigt. Auf diese Weise ist eine Montage vereinfacht und auch eine Robustheit erhöht. Zudem ist es nicht erforderlich, auf der Leiterplatte zusätzlichen Bauraum für die Antenne vorzusehen, sodass auf diese Weise eine Baugröße des Leiterplatte und somit auch des Hörgeräts verringert ist.

Beispielsweise weist die Leiterplatte einen Steckplatz auf, auf den Batteriemodul aufgesteckt ist. Somit ist das Batteriemodul lösbar an der Leiterplatte befestigt. Bevorzugt jedoch ist das Batteriemodul unlösbar mit der Leiterplatte verbunden. Besonders bevorzugt ist das Batteriemodul als oberflächenmontierbares Bauelement (SMD; "Surface Mounted Device") ausgestaltet. Mit anderen Worten ist das Batteriemodul insbesondere eines Reflow-Verfahrens oder mittels Lötens im Wellen- oder Schwallbad an der Leiterplatte befestigt. Aufgrund einer derartigen Ausgestaltung ist eine Baugröße des Batteriemoduls weiter verringert und eine Montage weiter vereinfacht. Insbesondere weist das Batteriemodul Pads auf, die in das Gehäuse eingebracht sind. Die Pads befinden sich insbesondere auf der der Leiterplatte zugewandten Seite des Gehäuses und liegen im Montagezustand an der Leiterplatte an und sind mit zumindest jeweils einer der Leiterbahnen verlötet. Über die Pads erfolgt dabei eine elektrische Kontaktierung der weiteren Bestandteile der Batteriezelle, wie insbesondere der Elektroden, mit der Leiterplatte, sodass ein Einspeisen und/oder Entnahme von elektrischer Energie über die Pads erfolgt. Vorzugsweise erfolgt hierbei mittels der Pads die Befestigung des Batteriemoduls an der Leiterplatte. Auf diese Weise erfolgt die elektrische Kontaktierung in einem Arbeitsschritt mit der Befestigung, und eine automatisierte Fertigung ist ermöglicht.

Beispielsweise sind mit der Antenne eine oder mehr Anschlüsse des Batteriemoduls elektrisch verbunden, die seitlich über das Gehäuse überstehen, und die im Montagezustand in entsprechende Aufnahmebuchsen gesteckt sind, die zum Beispiel an der Leiterplatte befestigt sind. Besonders bevorzugt jedoch ist in das Gehäuse ein Anschlusspad eingebracht, das elektrisch mit der Antenne verbunden ist. Das Anschlusspad befindet sich insbesondere auf der der Leiterplatte zugewandten Seite des Gehäuses und liegt im Montagezustand an der Leiterplatte geeigneterweise an. Vorzugsweise ist das Anschlusspad mit einer der Leiterbahnen der Leiterplatte verlötet oder zumindest elektrisch kontaktiert. Zweckmäßigerweise erfolgt die elektrische Kontaktierung im gleichen Arbeitsschritt, in dem auch die elektrische Kontaktierung der Batteriezelle mit der Leiterplatte erfolgt. Somit ist eine Anzahl an erforderlichen Arbeitsschritten reduziert und eine Montage vereinfacht. Auch ist eine Anzahl an benötigten Bauteilen verringert. Mit anderen Worten erfolgt die Kontaktierung der Antenne ebenfalls mittels Oberflächenmontage. Somit ist eine Robustheit weiter erhöht und eine Montage vereinfacht. Auch sind keine zusätzlichen Bauteile erforderlich. Besonders bevorzugt sind in das Gehäuse zwei derartige Anschlusspad eingebracht, wobei zwischen den Anschlusspads elektrisch die Antenne angeordnet ist. Somit ist ein Betrieb der Antenne vereinfacht.

Beispielsweise ist das Gehäuse aus einem Kunststoff gefertigt. Das Gehäuse weist metallischen Grundkörper auf, innerhalb dessen die weiteren Bestandteile der Batteriezelle angeordnet sind. Bevorzugt ist hierbei das Gehäuse starr ausgestaltet. Auf diese Weise erfolgt mittels des Grundkörpers auch eine Abschirmung der weiteren Bestandteile der Batteriezelle vor extern elektrischen Feldern. Zudem ist auf diese Weise eine Robustheit erhöht. Das oder die etwaigen Anschlusspads und/oder Pads sind insbesondere in Durchbrüchen des Grundkörpers angeordnet. Zwischen den Anschlusspads/Pads und dem Grundkörper ist vorzugsweise ein elektrischer Isolator vorhanden, wie ein Kunststoff, sodass einerseits ein elektrischer Kurzschluss verhindert ist. Andererseits ist auf diese Weise das Gehäuse, nämlich der Grundkörper, fluiddicht ausgestaltet, sodass eine Robustheit erhöht ist. Alternativ ist das oder die Anschlusspads auf eine Oberfläche des Grundkörpers aufgebracht, insbesondere über einen Isolator.

An dem Grundkörper ist die Antenne befestigt. Auf diese Weise ist die Befestigung der Antenne an den weiteren Bestandteilen des Batteriemoduls vergleichsweise robust. Beispielsweise ist die Antenne zumindest teilweise als Draht oder Flachleiter ausgebildet, der um das Gehäuse geschlungen ist. Vorzugsweise ist hierbei außenseitig auf den Grundkörper zunächst ein Isolator aufgebracht, beispielsweise vollständig oder teilweise. An dem Isolator ist die Antenne befestigt. Somit ist ein elektrischer Kurzschluss verhindert. Der Isolator und/oder die Antenne sind beispielsweise mittels Beschichtens, Gießens oder Drucks auf den Grundkörper aufgebracht.

Der Grundkörper weist eine schlitzförmige Öffnung auf, die mittels der Antenne verschlossen ist. Auf diese Weise ist auch weiterhin eine Fluiddichtigkeit des Grundkörpers gegeben, sodass die weiteren Bestandteile der Batteriezelle sicher geschützt sind. Beispielsweise ist hierbei die vollständige Öffnung mittels der Antenne ausgefüllt. Besonders bevorzugt jedoch ist die Antenne innerhalb der Öffnung beabstandet von weiteren Bestandteilen des Grundkörpers angeordnet, und zwischen dem Rand der Öffnung und der Antenne ist vorzugsweise ein Isolator angeordnet, insbesondere ein Kunststoff. Somit ist ein elektrischer Kurzschluss über den Grundkörper vermieden. Alternativ hierzu weist die Antenne beispielsweise eine zu dem Grundkörper abweichende elektrische Leitfähigkeit auf. Beispielsweise ist der Schlitz geradlinig oder vorzugsweise mäanderförmig ausgestaltet. Auf diese Weise ist eine Länge der Antenne vergleichsweise groß, wobei der Umfang des Grundkörpers vergleichsweise gering gewählt werden kann.

Beispielsweise ist das Gehäuse oder zumindest der etwaige Grundkörper, zylinderförmig ausgestaltet, wobei die Grundfläche beispielsweise rund ist. Besonders bevorzugt jedoch ist das Gehäuse quadratisch. Auf diese Weise ist eine Lagerhaltung und auch eine Montage vereinfacht. Besonders bevorzugt ist hierbei jede Kantenlänge kleiner als 2 cm, 1,5 cm oder 1 cm. Insbesondere ist die Kantenlänge zumindest einer der Kanten kleiner als 7 mm. Vorzugsweise ist die Kantenlänge hierbei größer als 1 Millimeter, 2 mm oder 4 mm. Aufgrund einer derartigen Wahl für die Länge der Kanten weist das Gehäuse eine vergleichsweise geringe Baugröße auf, sodass ein Einsatz innerhalb des Hörgeräts vereinfacht ist. Dabei weist die Batteriezelle dennoch eine vergleichsweise hohe Kapazität auf, sodass auch ein lang andauernder Betrieb des Hörgeräts möglich ist.

Beispielsweise ist lediglich die Antenne vorhanden. In einer Alternative hierzu weist das Hörgerät eine weitere Antenne auf. Hierbei dient die weitere Antenne beispielsweise der Kommunikation auf einem anderen Frequenzband/mit einem anderen Standard als die Antenne. Besonders bevorzugt jedoch ist die weitere Antenne elektrisch mit der Antenne verbunden, sodass die weitere Antenne und die Antenne eine gemeinsame Antenne bilden, die eine vergrößerte effektive Länge aufweist. Beispielsweise ist die weitere Antenne mittels einer Spule gebildet. Besonders bevorzugt jedoch ist die weitere Antenne mittels einer Leiterbahn der Leiterplatte gebildet. Auf diese Weise ist eine Anzahl an benötigten Bauelementen verringert. Zum Beispiel ist die Leiterbahn zumindest teilweise mäanderförmig ausgestaltet. Vorzugsweise ist die weitere Leiterbahn elektrisch mit der etwaigen Funkvorrichtung/Funkeinrichtung elektrisch kontaktiert, sodass ein Anregen der Antenne und/oder Überprüfen einer Anregung der Antenne über die weitere Antenne erfolgt.

Nachfolgend wird ein Ausführungsbeispiel der Erfindung anhand einer Zeichnung näher erläutert. Darin zeigen:
- Fig. 1: schematisch ein Hörgerät,
- Fig. 2: perspektivisch vereinfacht eine Leiterplatte des Hörgeräts, an der ein Batteriemodul befestigt ist,
- Fig. 3: das Batteriemodul in einer Unteransicht, und
- Fig. 4: schematisch vereinfacht ausschnittsweise ein Gehäuse des Batteriemoduls in einer Seitenansicht.

Einander entsprechende Teile sind in allen Figuren mit den gleichen Bezugszeichen versehen.

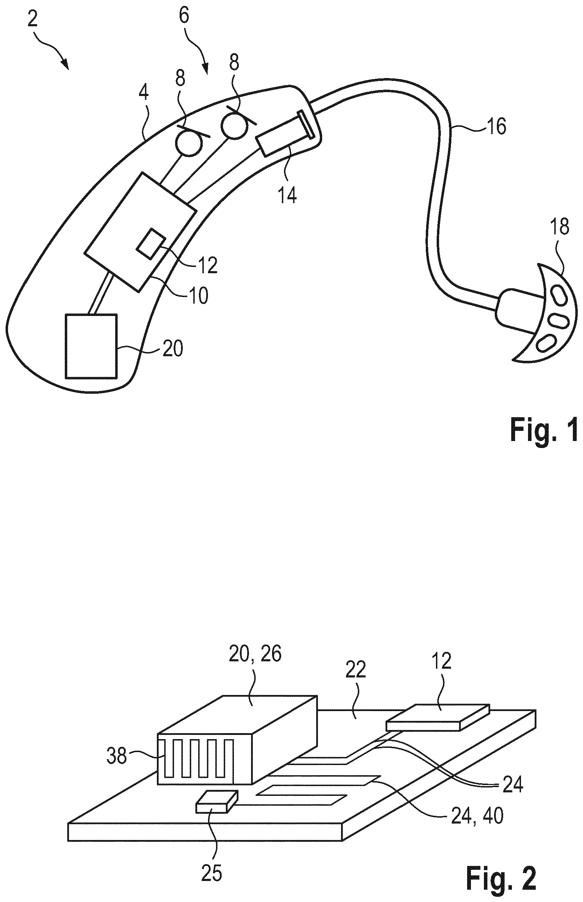

In Figur 1 ist schematisch ein Hörgerät 2 in Form eines Hörhilfegeräts gezeigt, das vorgesehen und eingerichtet ist, hinter einem Ohr eines Trägers (Benutzer, Hörgeräteträger, Nutzer) getragen zu werden. Mit anderen Worten handelt es sich um ein Hinter-dem-Ohr-Hörhilfegerät ("Behind-the-Ear" - Hörhilfegerät). Das Hörgerät 2 umfasst ein Gerätegehäuse 4, das aus einem Kunststoff gefertigt ist. Innerhalb des Gerätegehäuses 4 ist ein Mikrofon 6 mit zwei Mikrofoneinheiten 8 in Form von jeweils einem elektromechanischen Schallwandlern angeordnet, die omnidirektional ausgestaltet sind. Indem ein zeitlicher Versatz zwischen den mittels der omnidirektionalen Mikrofoneinheiten 8 erfassten akustischen Signalen verändert wird, ist es ermöglicht, eine Richtcharakteristik des Mikrofons 6 zu verändern, sodass ein Richtmikrofon realisiert ist.

Die beiden Mikrofoneinheiten 8 sind mit einer Signalverarbeitungseinheit 10 signaltechnisch gekoppelt, die eine nicht näher gezeigte Verstärkerschaltung und einen Signalprozessor 12 umfasst. Die Signalverarbeitungseinheit 10 ist ferner mittels Schaltungselementen gebildet, wie zum Beispiel elektrischen und/oder elektronischen Bauteilen. Der Signalprozessor ist ein digitaler Signalprozessor (DSP) und über einen nicht näher dargestellten A/D-Wandler signaltechnisch mit den Mikrofoneinheiten 8 verbunden.

Mit der Signalverarbeitungseinheit 10 ist ein Hörer 14 signaltechnisch gekoppelt. Mittels des Hörers 14, der ein elektromechanischer Schallwandler ist, wird bei Betrieb ein mittels der Signalverarbeitungseinheit 10 bereitgestelltes (elektrisches) Signal in einen Ausgabeschall gewandelt, also in Schallwellen. Diese werden in einen Schallschlauch 16 eingeleitet, dessen eines Ende an dem Gerätegehäuse 4 befestigt ist. Das andere Ende des Schallschlauchs 16 ist mittels eines Doms 18 umschlossen, der im bestimmungsgemäßen Zustand in einem hier nicht näher dargestellten Gehörgang des Trägers des Hörgeräts 2, angeordnet ist.

Die Bestromung der Signalverarbeitungseinheit 10 erfolgt mittels eines in dem Gerätegehäuse 4 angeordneten Batteriemoduls 20. Von der Signalverarbeitungseinheit 10 wird ein Teil der elektrischen Energie zu dem Mikrofon 6 sowie der Hörer 14 geleitet.

In Figur 2 ist schematisch vereinfacht ausschnittsweise eine Leiterplatte 22 des Hörgeräts 2 dargestellt, die aus einem glasfaserverstärkten Epoxidharz gefertigt ist. An einer Oberfläche des es auf diese Weise bereitgestellten Epoxidharzkörpers sind mehrere Leiterbahnen 24 aus einem Kupfer angebunden, von denen hier lediglich drei dargestellt sind. An der Leiterplatte 22 ist der Signalprozessor 12 befestigt, nämlich an einigen der Leiterbahnen 24. Hierfür ist der Signalprozessor 12 an diesen mittels SMD-Techniken angelötet, nämlich in einem Reflow-Verfahren. Auf der gleichen Seite der der Leiterplatte 22 wie der Signalprozessor 12 ist das Batteriemodul 20 befestigt, das ebenfalls mit einigen der Leiterbahn 24 elektrisch kontaktiert ist, über die auch die Bestromung des Signalprozessors 12 erfolgt. Zudem ist auf dieser Seite der Leiterplatte 22 eine Funkvorrichtung 25 befestigt ist, bei der es um einen integrierten Schaltkreis handelt, der ebenfalls als oberflächenmontierbares Bauteil ausgestaltet ist. An der Leiterplatte 22 sind ferner weitere nicht näher dargestellte elektrische und/oder elektronische angelötet, sodass die Leiterplatte 32 der Bereitstellung der elektrischen Schaltung des Hörgeräts 2 dient. Mit anderen Worten ist die Leiterplatte 22 ein Bestandteil der elektrischen Schaltung, und das Hörgerät 2 weist ansonsten keine weitere Leiterplatte auf.

Das Batteriemodul 20 weist ein Gehäuse 26 auf, das quadratisch ausgestaltet ist. Hierbei ist die Länge von vier zueinander parallelen Kanten gleich 1 cm, und die Länge der verbleibenden Kanten beträgt 0,5 cm. Das Gehäuse 26 weist einen metallischen Grundkörper 28 auf, der ebenfalls quadratisch ausgestaltet ist, und mittels dessen im Wesentlichen die Außenform des Gehäuses 26 vorgegeben ist.

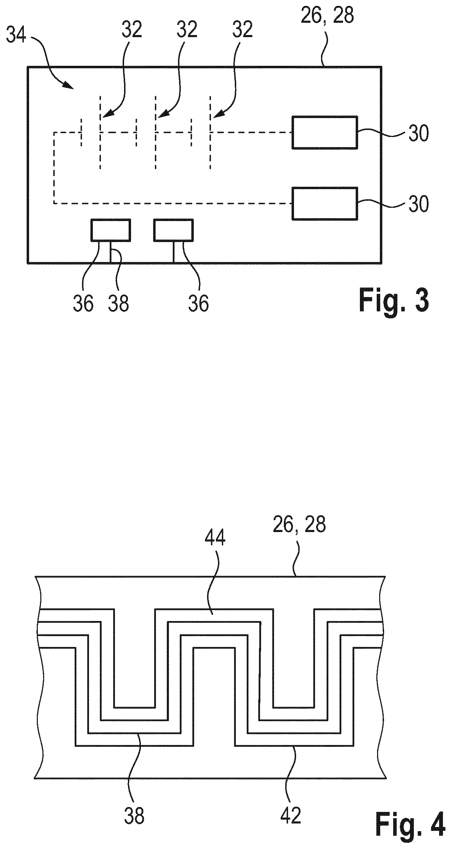

In Figur 3 ist schematisch vereinfacht die Unterseite des Grundkörpers 28 und somit auch die Unterseite des Gehäuses 26 gezeigt. Im Montagezustand ist die Unterseite der Leiterplatte 22 zugewandt und liegt beispielsweise zumindest abschnittsweise an dieser an. In die Unterseite des Gehäuses 26 sind zwei Pads 30 aus einem Metall, wie Kupfer, eingebracht. Hierfür weist der Grundkörper 28 zwei Durchbrüche auf, innerhalb der jeweils eines der Pads 30 angeordnet ist. Der zwischen dem Rand jedes Durchbruchs und dem korrespondierenden Pad 30 vorhandene Schlitz ist jeweils mit einem elektrischen Kunststoff ausgefüllt, sodass die Pads 30 von dem Grundkörper 28 elektrisch isoliert jedoch an diesem sicher gehalten sind.

Mit den Pads 30 sind mehrere galvanische Zellen 32 elektrisch kontaktiert, die innerhalb des Grundkörpers 28 somit innerhalb des Gehäuses 26 angeordnet sind. Mittels des Gehäuses 26 sowie der galvanischen Zellen 32 ist im Wesentlichen eine Batteriezelle 34 des Batteriemoduls 20 gebildet, mittels derer die Bestromung der Signalverarbeitungseinheit 10 erfolgt. Im Montagezustand ist jedes der Pads 30 mit jeweils zumindest einer der Leiterbahnen 24 elektrisch kontaktiert, wobei dies ebenfalls in einem Reflow-Verfahren, also in SMD-Technik, erfolgte.

Zudem sind auf die gleiche Seite des quaderförmigen Grundkörpers 28 zwei Anschlusspads 36 aufgebracht und unlösbar daran befestigt, sodass die Anschlusspads 36 in das Gehäuse 26 eingebracht sind. Hierbei sind die Anschlusspads 36 über einen nicht näher dargestellten elektrischen Isolator an dem Grundkörper 28 befestigt. Mit den Anschlusspads 36 ist eine Antenne 38 elektrisch verbunden, die sich zwischen den beiden Anschlusspads 36 elektrisch erstreckt. Hierbei ist die Antenne 38 geometrisch von der Unterseite des quaderförmigen Grundkörpers 28 auf zumindest eine der zur Leiterplatte 22 senkrecht verlaufenden Seiten des Grundkörpers 28 geführt. Dort ist die Form der Antenne 38 mäanderförmig.

Im Montagezustand sind die beiden Anschlusspads 36 ebenfalls mittels eines Reflow-Verfahrens an der Leiterplatte 22 angelötet, was in dem gleichen Arbeitsschritt erfolgt, in dem auch die Pads 30 mit der Leiterplatte 20 verlötet werden. In diesem Arbeitsschritt werden auch der Signalprozessor 12, die Funkvorrichtung 25 sowie die etwaigen weiteren Bestandteile mit der Leiterplatte 22 verlötet. Zusammenfassend handelt es sich bei dem Batteriemodul 20 somit um ein oberflächenmontierbares Bauelement/Bauteil.

Eines der Anschlusspads 36 ist mit einer der Leiterbahnen 24 der Leiterplatte 22 elektrisch kontaktiert, die ebenfalls mäanderförmig ausgestaltet ist, sodass mittels dieser eine weitere Antenne 40 gebildet ist. Mittels der weiteren Antenne 40 ist die Antenne 38 mit der Funkvorrichtung 25 elektrisch kontaktiert. Somit ist mittels der weiteren Antenne 40 und der Antenne 38 eine gemeinsame Antenne gebildet, die eine vergleichsweise große Länge aufweist. Zusammenfassend ist die weitere Antenne 40 mit der Antenne 38 elektrisch verbunden sowie mittels einer der Leiterbahnen 24 gebildet.

Bei Betrieb erfolgt mittels der Funkvorrichtung 25 ein Anregen der weiteren Antenne 40 sowie der Antenne 38, sodass mittels dieser Funksignale ausgesandt werden. Diese erfüllen einen bestimmten Standard, wie einen Bluetooth-Standard. In einem hierzu zeitlich versetzten Betriebsmodus erfolgt mittels der Antenne 38 sowie der weiteren Antenne 40 ein Empfangen von Funksignalen, mittels derer diese angeregt werden. Auch diese Funksignale erfüllen dabei den Standard. Die Anregung der beiden Antennen 38, 30 wird mittels der Funkvorrichtung 25 erfasst, sodass die Funksignale erfasst werden. Anhand der Funksignale wird beispielsweise eine Funktionsweise des Signalprozessors 12 abgewandelt.

In Figur 4 ist in einer Seitenansicht ausschnittsweise das Gehäuse 26 mit dem quaderförmigen Grundkörper 28 dargestellt. Der Grundkörper 28 weist eine schlitzförmige Öffnung 42 auf, die mäanderförmig ausgestaltet ist. Innerhalb der Öffnung 42 ist die bandförmig ausgestaltete und den Verlauf der Öffnung 42 nachahmende Antenne 38 angeordnet, wobei diese zu dem Rand der Öffnung 42 beabstandet ist. Der Bereich zwischen der Antenne 38 und dem Rand der Öffnung 42 ist mittels eines Isolators 44 aus einem Kunststoff befüllt. Der Isolator 44 ist hierbei mittels eines Spritzgussverfahrens erstellt, und die Antenne 38 ist somit an den Grundkörper 28 angespritzt. Somit ist der Grundkörper 28 fluiddicht ausgestaltet, und ein Eindringen von Umgebungsluft in das Gehäuse 26 ist vermieden.

In einer nicht näher dargestellten Variante, die nicht Teil der Erfindung darstellt, ist der Grundkörper 28 unversehrt ausgestaltet, und weist somit nicht die Öffnung 42 auf. Hierbei ist der Isolator 44 beispielsweise auf die Oberfläche des Grundkörpers 28 aufgespritzt, sodass mittels dessen die Antenne 38 an dem Grundkörper 28 verliersicher und unlösbar gehalten ist. Zusammenfassend ist bei sämtlichen Ausführungsformen die Antenne 38 in das Gehäuse 26 der Batteriezelle 34 integriert. Die elektrische Kontaktierung der Antenne 38 erfolgt im gleichen Arbeitsschritt, in dem auch die Batteriezelle 34 mit der Leiterplatte 22 elektrisch kontaktiert und an dieser befestigt wird, nämlich mittels Oberflächenmontage.

Die Erfindung ist nicht auf das vorstehend beschriebene Ausführungsbeispiel beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit dem Ausführungsbeispiel beschriebene Einzelmerkmale auch auf andere Weise miteinander kombinierbar, ohne den Gegenstand der Erfindung zu verlassen.

## Patentansprüche

1. Hörgerät (2) mit einer Leiterplatte (22), an der ein Batteriemodul (20) befestigt ist, das eine Batteriezelle (34) mit einem Gehäuse (26) aufweist, wobei die Batteriezelle Elektroden und einen Elektrolyten umfasst, die direkt innerhalb des Gehäuses (26) angeordnet sind, wobei zwischen diesen kein weiteres Bauteil vorhanden ist, wobei in das Gehäuse (26) eine Antenne (38) integriert ist, wobei die Antenne (38) unlösbar an dem Gehäuse (26) verbunden ist, wobei das Gehäuse (26) einen metallischen Grundkörper (28) aufweist, an dem die Antenne (38) befestigt ist, und wobei der Grundkörper (28) eine schlitzförmige Öffnung (42) aufweist, die mittels der Antenne (38) verschlossen ist.

2. Hörgerät (2) nach Anspruch 1,
**dadurch gekennzeichnet,**
**dass** das Batteriemodul (20) als oberflächenmontierbares Bauelement ausgestaltet ist.

3. Hörgerät (2) nach Anspruch 2,
**dadurch gekennzeichnet,**
**dass** in das Gehäuse (26) ein Anschlusspad (36) eingebracht ist, das elektrisch mit der Antenne (38) verbunden ist.

4. Hörgerät (2) nach einem der Ansprüche 1 bis 3,
**dadurch gekennzeichnet,**
**dass** das Gehäuse (26) quadratisch ist.

5. Hörgerät (2) nach einem der Ansprüche 1 bis 4,
**dadurch gekennzeichnet,**
**dass** die Leiterplatte (22) eine weitere Antenne (40) aufweist, die mittels einer Leiterbahn (24) gebildet ist, und die mit der Antenne (38) elektrisch verbunden ist.

## Claims

1. Hearing aid (2) having a printed circuit board (22) to which a battery module (20) is fastened, which module comprises a battery cell (34) having a housing (26), wherein the battery cell comprises electrodes and an electrolyte which are arranged directly in the housing (26), wherein no further component is present therebetween, wherein an antenna (38) is integrated in the housing (26), wherein the antenna (38) is permanently bonded to the housing (26), wherein the housing (26) comprises a metallic base structure (28) to which the antenna (38) is fastened, and wherein the base structure (28) comprises a slot-shaped opening (42) which is closed by means of the antenna (38).

2. Hearing aid (2) according to Claim 1,
**characterized in that**
the battery module (20) is configured as a surface-mounted device.

3. Hearing aid (2) according to Claim 2,
**characterized in that**
a terminal pad (36) which is electrically bonded to the antenna (38) is introduced into the housing (26).

4. Hearing aid (2) according to one of Claims 1 to 3,
**characterized in that**
the housing (26) is quadratic.

5. Hearing aid (2) according to one of Claims 1 to 4,
**characterized in that**
the printed circuit board (22) comprises a further antenna (40) which is formed by a printed conductor (24) and is electrically bonded to the antenna (38).

## Revendications

1. Appareil auditif (2) comprenant une carte de circuit imprimé (22), sur laquelle est fixé un module de batterie (20), le module de batterie comprenant une cellule de batterie (34) comportant un boîtier (26), la cellule de batterie comprenant des électrodes et un électrolyte qui sont disposés directement à l'intérieur du boîtier (26), sans qu'aucun autre composant ne soit présent entre ceux-ci, une antenne (38) étant intégrée dans le boîtier (26), l'antenne (38) étant reliée de manière inamovible au boîtier (26), le boîtier (26) comportant un corps de base métallique (28) auquel est fixée l'antenne (38), et le corps de base (28) présentant une ouverture en forme de fente (42) qui est fermée au moyen de l'antenne (38).

2. Appareil auditif (2) selon la revendication 1,
**caractérisé**
**en ce que** le module de batterie (20) est conçu sous forme de composant pouvant être monté en surface.

3. Appareil auditif (2) selon la revendication 2,
**caractérisé**
**en ce qu'**un plot de connexion (36) est inséré dans le boîtier (26), et est connecté électriquement à l'antenne (38).

4. Appareil auditif (2) selon l'une quelconque des revendications 1 à 3,
**caractérisé**
**en ce que** le boîtier (26) est carré.

5. Appareil auditif (2) selon l'une quelconque des revendications 1 à 4,
**caractérisé**
**en ce que** la carte de circuit imprimé (22) comporte une autre antenne (40) qui est formée au moyen d'une piste conductrice (24) et est connectée électriquement à l'antenne (38).
